# DEMANDE DE BREVET EUROPEEN

(11) **EP 3 754 697 A1**
(43) Date de publication de la demande: **23.12.2020**
(21) Numéro de dépôt: 20180943.1
(22) Date de dépôt: 18.06.2020
(51) Int. Cl.: H01L 21/8252, H01L 27/06, H01L 29/20, H01L 29/872, H01L 27/02, H01L 29/778, H01L 29/10, H01L 29/205, H01L 29/417, H01L 29/423

(54) **COMPOSANT MONOLITHIQUE COMPORTANT UN TRANSISTOR DE PUISSANCE AU NITRURE DE GALLIUM**

(30) Priorité: 19.06.2019 FR 1906589
(71) Demandeur: STMicroelectronics Application GmbH, 85609 Aschheim (DE); STMicroelectronics (Tours) SAS, 37100 Tours (FR)
(72) Inventeur: ROUVIERE, Mathieu, 37000 TOURS (FR); YVON, Arnaud, 37540 SAINT-CYR SUR LOIRE (FR); SAADNA, Mohamed, 37540 SAINT CYR-SUR-LOIRE (FR); SCARPA, Vladimir, 40213 DÜSSELDORF (DE)
(74) Mandataire: Cabinet Beaumont

(57) **Abrégé**

La présente description concerne un composant (200) monolithique comportant un transistor de puissance à effet de champ (Tl) et deux diodes Schottky (SC1, SC2) dans et sur un même substrat au nitrure de gallium (301).

## Description

### Domaine technique

La présente description concerne de façon générale le domaine des composants électroniques de puissance, et vise plus particulièrement un composant électronique monolithique comportant un transistor de puissance à effet de champ au nitrure de gallium.

### Technique antérieure

Diverses familles technologiques de transistors de puissance à effet de champ ont été proposées, parmi lesquelles on trouve notamment les transistors au silicium, les transistors au carbure de silicium, et les transistors au nitrure de gallium.

On s'intéresse ici plus particulièrement aux transistors de puissance à effet de champ au nitrure de gallium.

Il serait souhaitable de pallier au moins en partie certains des inconvénients des composants électroniques connus intégrant des transistors à effet de champ au nitrure de gallium.

### Résumé de l'invention

Un mode de réalisation prévoit un composant monolithique comportant un transistor de puissance à effet de champ et au moins une première diode Schottky dans et sur un même substrat au nitrure de gallium.

Selon un mode de réalisation, la première diode Schottky a une première électrode connectée à la grille du transistor et une deuxième électrode connectée à une première borne de connexion du composant.

Selon un mode de réalisation, la première borne de connexion est destinée à recevoir une première tension fixe correspondant à une tension de commande du transistor dans un premier état, fermé ou ouvert.

Selon un mode de réalisation, le composant comporte en outre une deuxième diode Schottky formée dans et sur le substrat au nitrure de gallium.

Selon un mode de réalisation, la deuxième diode Schottky a une première électrode connectée à la grille du transistor et une deuxième électrode connectée à une deuxième borne de connexion du composant.

Selon un mode de réalisation, la deuxième borne de connexion est destinée à recevoir une deuxième tension fixe correspondant à une tension de commande du transistor dans un deuxième état, ouvert ou fermé.

Selon un mode de réalisation, le composant comporte en outre une borne de connexion de drain, une borne de connexion de source et une borne de connexion de grille connectées respectivement au drain, à la source et à la grille du transistor.

Un autre mode de réalisation prévoit un circuit comportant :
- un composant tel que défini ci-dessus ; et
- un premier condensateur connecté entre la première borne de connexion du composant et la borne de connexion de source du composant.

Selon un mode de réalisation, le circuit comporte en outre un deuxième condensateur connecté entre la deuxième borne de connexion du composant et la borne de connexion de source du composant.

Selon un mode de réalisation, le circuit comporte en outre un circuit de commande comportant une première borne de connexion fournissant une première tension fixe correspondant à une tension de commande du transistor dans un premier état, fermé ou ouvert, une deuxième borne de connexion, et un premier interrupteur commandé reliant la première borne de connexion du circuit de commande à la deuxième borne de connexion du circuit de commande, la première borne de connexion du circuit de commande étant connectée à la première borne de connexion du composant, et la deuxième borne de connexion du circuit de commande étant reliée à la borne de connexion de grille du composant.

Selon un mode de réalisation, le circuit de commande comporte une troisième borne de connexion fournissant une deuxième tension fixe correspondant à une tension de commande du transistor dans un deuxième état, ouvert ou fermé, une quatrième borne de connexion, et un deuxième interrupteur commandé reliant la troisième borne de connexion du circuit de commande à la quatrième borne de connexion du circuit de commande, la troisième borne de connexion du circuit de commande étant connectée à la deuxième borne de connexion du composant, et la quatrième borne de connexion du circuit de commande étant reliée à la borne de connexion de grille du composant.

Un autre mode de réalisation prévoit un procédé de fabrication d'un composant tel que défini ci-dessus, comportant les étapes successives suivantes :
a) prévoir un substrat au nitrure de gallium ;
b) former la grille du transistor du côté de la face supérieure du substrat ;
c) déposer une couche de passivation ;
d) former une tranchée dans la couche de passivation ; et
e) former dans ladite tranchée une métallisation définissant l'anode de la première diode Schottky.

Selon un mode de réalisation :
- avant l'étape b), le substrat est revêtu d'une couche de nitrure d'aluminium-gallium ;
- à l'étape d), la tranchée formée dans la couche de passivation débouche dans ou sur la couche de nitrure d'aluminium-gallium, ou dans ou sur le substrat ; et
- à l'étape e), la métallisation formée dans ladite tranchée forme un contact Schottky avec la couche de nitrure d'aluminium-gallium, ou avec le substrat.

Selon un mode de réalisation, à l'étape b), une ouverture localisée débouchant dans ou sur le substrat est formée dans la couche de nitrure d'aluminium-gallium, puis un empilement de grille isolée définissant la grille du transistor est formé dans ladite ouverture.

Selon un mode de réalisation, à l'étape b), une région semiconductrice à base de nitrure de gallium est formée par épitaxie localisée sur la face supérieure de la couche de nitrure d'aluminium-gallium, puis une métallisation définissant la grille du transistor est formée sur et en contact avec la face supérieure de ladite région.

Selon un mode de réalisation, le procédé comporte en outre, après la formation de la couche de passivation, les étapes successives suivantes :
- former simultanément dans la couche de passivation de première, deuxième et troisième tranchées débouchant dans ou sur le substrat ; et
- former simultanément dans les première, deuxième et troisième tranchées des première, deuxième et troisième métallisations formant chacune un contact ohmique avec le substrat et définissant respectivement un contact de cathode de la première diode Schottky, un contact de source du transistor et un contact de drain du transistor.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'un circuit comportant un composant monolithique intégrant un transistor de puissance à effet de champ au nitrure de gallium ;
la figure 2 est un schéma électrique d'un exemple d'un circuit comportant un mode de réalisation d'un composant monolithique intégrant un transistor de puissance à effet de champ au nitrure de gallium ;
la figure 3 illustre une étape d'un procédé de fabrication d'un composant monolithique intégrant un transistor de puissance à effet de champ au nitrure de gallium selon un mode de réalisation ;
la figure 4 illustre une autre étape du procédé de la figure 3 ;
la figure 5 illustre une autre étape du procédé des figures 3 et 4 ;
la figure 6 illustre une autre étape du procédé des figures 3 à 5 ;
la figure 7 illustre une autre étape du procédé des figures 3 à 6 ;
la figure 8 illustre une variante de l'étape de la figure 7 ;
la figure 9 illustre une autre étape du procédé des figures 3 à 8 ;
la figure 10 illustre une autre étape du procédé des figures 3 à 9 ;
la figure 11 illustre une autre étape du procédé des figures 3 à 10 ; et
la figure 12 illustre une variante du procédé des figures 3 à 11.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses utilisations qui peuvent être faites des composants de puissance décrits n'ont pas été détaillées, les modes de réalisation décrits étant compatibles avec les applications usuelles de composants monolithiques intégrant des transistors de puissance à effet de champ au nitrure de gallium. De plus, la réalisation des circuits de commande des composants décrits n'a pas été détaillée, la réalisation de tels circuits étant à la portée de l'homme du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les structures décrites peuvent être orientées différemment.

Sauf précision contraire, les expressions "environ", "approximativement", "sensiblement", et "de l'ordre de" signifient à 10 % près, de préférence à 5 % près.

On notera que par transistor de puissance, on entend ici un transistor adapté à tenir des tensions relativement élevées à l'état ouvert (bloqué), par exemple des tensions supérieures à 100 V et de préférence supérieures à 500 V, et à laisser passer des courants relativement élevés à l'état fermé (passant), par exemple des courants supérieurs à 1 A et de préférence supérieurs à 5 A.

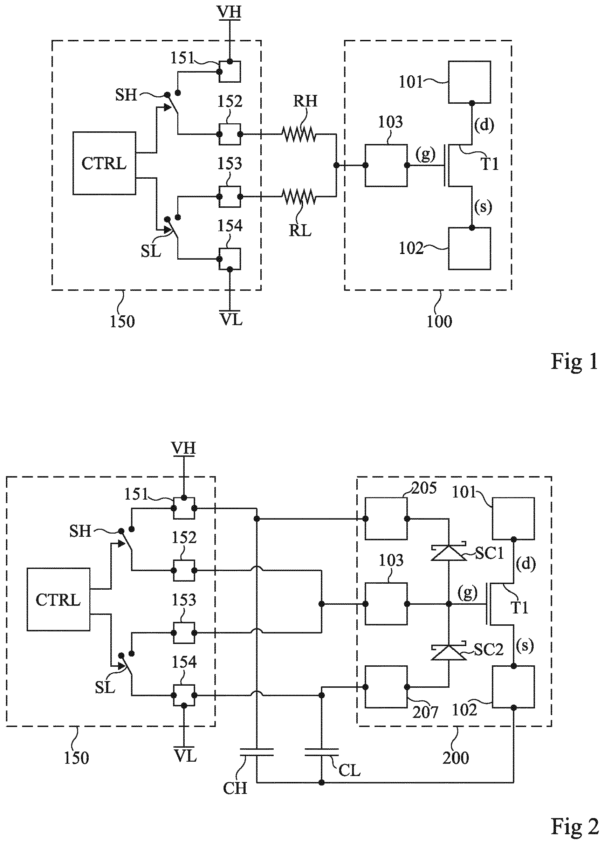

La figure 1 est un schéma électrique d'un circuit comportant un composant 100 monolithique intégrant un transistor de puissance à effet de champ au nitrure de gallium T1.

Le transistor T1 est formé dans et sur un substrat à base de nitrure de gallium (non visible sur la figure 1), par exemple un substrat de nitrure de gallium massif, un substrat comportant une couche de nitrure de gallium sur un support en silicium, un substrat comportant une couche de nitrure de gallium sur un support en carbure de silicium, ou un substrat comportant une couche de nitrure de gallium sur un support en saphir. A titre d'exemple, le transistor T1 est un transistor HEMT (de l'anglais "High Electron Mobility Transistor" - transistor à haute mobilité d'électrons).

Le composant 100 peut comprendre un boîtier d'encapsulation (non détaillé sur la figure), par exemple en un matériau isolant, laissant accessibles trois bornes métalliques de connexion à un dispositif extérieur 101, 102 et 103, connectées respectivement au drain (d), à la source (s) et à la grille (g) du transistor T1.

Le circuit de la figure 1 comprend en outre un circuit 150 de commande du transistor T1. Le circuit 150 est par exemple un circuit intégré externe au boîtier du composant 100, réalisé dans et sur un substrat semiconducteur distinct du substrat du transistor 100, par exemple un substrat de silicium. Dans cet exemple, le circuit 150 comprend quatre bornes métalliques de connexion 151, 152, 153 et 154.

Les bornes 151 et 154 sont destinées à recevoir respectivement une tension de commande haute VH et une tension de commande basse VL, fournies par un circuit d'alimentation externe au circuit 150, non détaillé sur la figure. Les tensions VH et VL sont référencées par rapport à la borne 102 de source (s) du transistor T1. La tension VH peut être une tension positive, et la tension VL peut être une tension négative ou nulle. A titre d'exemple, la tension VH est comprise dans la plage allant de 2 à 15 V, par exemple de l'ordre de 6 volts, et la tension VL est comprise dans la plage allant de -10 à 0 V, par exemple de l'ordre de -3 V.

Les bornes 152 et 153 sont des bornes de fourniture de signaux de commande haut et bas destinées à être reliées à la borne 103 de grille (g) du transistor T1. Dans cet exemple, la borne 152 est reliée à la borne 103 par une résistance RH, et la borne 153 est reliée à la borne 103 par une résistance RL. Plus particulièrement, la résistance RH a une première extrémité reliée, par exemple connectée, à la borne 152 et une deuxième extrémité reliée, par exemple connectée, à la borne 103, et la résistance RL a une première extrémité reliée, par exemple connectée, à la borne 153 et une deuxième extrémité reliée, par exemple connectée, à la borne 103. Les résistances RH et RL sont par exemple des résistances discrètes externes au circuit 150 et au composant 100.

Le circuit 150 comprend en outre un interrupteur SH reliant, par ses noeuds de conduction, la borne 151 à la borne 152, et un interrupteur SL reliant, par ses noeuds de conduction, la borne 154 à la borne 153. Les interrupteurs SH et SL sont par exemple des transistors MOS commandés en commutation. A titre d'exemple, le transistor SH est un transistor MOS à canal P dont la source est reliée, par exemple connectée, à la borne 151 et dont le drain est relié, par exemple connecté, à la borne 153, et le transistor SL est un transistor MOS à canal N dont la source est reliée, par exemple connectée, à la borne 154 et dont le drain est relié, par exemple connecté, à la borne 153.

Le circuit 150 comprend de plus un circuit CTRL de commande des interrupteurs SH et SL. Le circuit CTRL est adapté à appliquer à chacun des interrupteurs SH et SL, sur un noeud de commande de l'interrupteur, par exemple la grille dans le cas d'un transistor MOS, un signal de commande en ouverture ou en fermeture de l'interrupteur. Le circuit CTRL est configuré pour ne jamais commander en même temps la fermeture de l'interrupteur SH et la fermeture de l'interrupteur SL, afin de ne pas court-circuiter les bornes 151 et 152.

Le fonctionnement du circuit de la figure 1 est le suivant. Pour fermer le transistor T1, le circuit CTRL commande l'ouverture de l'interrupteur SL et la fermeture de l'interrupteur SH. Ceci conduit à l'application d'une tension sensiblement égale à la tension VH entre la grille et la source du transistor T1, entraînant la fermeture du transistor T1. Pour ouvrir le transistor T1, le circuit CTRL commande l'ouverture de l'interrupteur SH et la fermeture de l'interrupteur SL. Ceci conduit à l'application d'une tension sensiblement égale à la tension VL entre la grille et la source du transistor T1, entraînant l'ouverture du transistor T1.

Une limitation du montage de la figure 1 est liée aux inductances parasites de connexion entre le transistor T1 et le circuit 150. Ces inductances entraînent l'apparition d'oscillations et/ou de pics de tension entre la grille et la source du transistor T1 lors des commutations du transistor T1 de l'état passant (fermé) à l'état bloqué (ouvert) et/ou lors des commutations du transistor T1 de l'état bloqué à l'état passant, pouvant conduire à des dysfonctionnements. En particulier, la tension grille-source du transistor peut atteindre, en valeur absolue, une tension supérieure à la tension grille-source maximale que peut supporter le transistor. Il en résulte un risque de dégradation de la grille du transistor T1. Ceci pose tout particulièrement problème dans le cas de transistors de puissance au nitrure de gallium. En effet, dans les technologies usuelles de réalisation de transistors à effet de champ au nitrure de gallium, et notamment de transistors HEMT au nitrure de gallium, la tension grille source maximale VGSMAX que peut supporter sans dégradation le transistor est généralement très proche de la tension de commande haute VH du transistor, et la tension grille source minimale VGSMIN que peut supporter sans dégradation le transistor est généralement très proche de la tension de commande basse VL du transistor. A titre d'exemple, la tension VGSMAX est supérieure de moins de 5 V, par exemple de moins de 2 V, à la tension VH. A titre d'exemple, la tension VGSMIN est inférieure de moins de 10 V, par exemple de moins de 5 V, à la tension VL. Il en résulte que des oscillations et/ou pics de tension parasites sur la grille du transistor T1, même d'amplitudes relativement faibles, peuvent provoquer une dégradation de la grille du transistor T1.

Les résistances RH et RL permettent de limiter la pente du courant entre la source et le drain du transistor T1 lors des commutations, et par conséquent l'amplitude des oscillations et/ou pics de tension parasites sur la grille du transistor T1 lors des commutations. Ceci permet de protéger la grille du transistor, mais au détriment de la vitesse de commutation des transistors qui s'en trouve réduite.

Selon un aspect d'un mode de réalisation, on prévoit un composant monolithique comportant un transistor de puissance à effet de champ au nitrure de gallium, ce composant comportant en outre au moins une diode Schottky connectée à la grille du transistor de puissance, permettant d'éviter l'apparition de surtensions destructrices sur la grille du transistor, sans avoir à réduire sa vitesse de commutation.

La figure 2 est un schéma électrique d'un exemple d'un circuit comportant un composant monolithique 200 selon un mode de réalisation.

Le circuit de la figure 2 comprend des éléments communs avec le circuit de la figure 1. Dans la suite, ces éléments communs ne seront pas détaillés à nouveau, et seules les différences entre les deux circuits seront mises en exergue.

Le composant 200 de la figure 2 comprend les mêmes éléments que le composant 100 de la figure 1, à savoir un transistor T1 formé dans et sur un substrat à base de nitrure de gallium (non visible sur la figure 2), par exemple un transistor HEMT, et un boîtier d'encapsulation (non détaillé sur la figure), par exemple en un matériau isolant, laissant accessibles trois bornes métalliques de connexion à un dispositif extérieur 101, 102 et 103, connectées respectivement au drain (d), à la source (s) et à la grille (g) du transistor T1.

Le composant 200 de la figure 2 comprend en outre deux diodes Schottky SC1 et SC2, par exemple identiques ou similaires, formées dans et sur le même substrat au nitrure de gallium que le transistor T1. La diode Schottky SC1 a son anode reliée, par exemple connectée, à la grille du transistor T1 et la diode Schottky SC2 a sa cathode reliée, par exemple connectée, à la grille du transistor T1.

Dans cet exemple, le boîtier d'encapsulation du composant laisse en outre accessibles deux bornes métalliques de connexion à un dispositif extérieur 205 et 207, distinctes des bornes 101, 102 et 103, reliées, par exemple connectées, respectivement à la cathode de la diode Schottky SC1 et à l'anode de la diode Schottky SC2.

Le circuit de la figure 2 comprend en outre un circuit 150 de commande du transistor T1, identique ou similaire au circuit 150 de la figure 1.

Dans cet exemple, les résistances RH et RL sont omises, c'est-à-dire que les bornes de commande 152 et 153 du circuit 150 sont directement connectées à la borne 103 du composant 200.

De plus, dans cet exemple, les bornes 151 et 154 du circuit 150 sont connectées respectivement aux bornes 205 et 207 du composant 200.

Le circuit de la figure 2 comprend en outre un condensateur CH ayant une première électrode reliée, par exemple connectée, à la borne 205 du composant 200 et une deuxième électrode reliée, par exemple connectée, à la borne 102 du composant 200, et un condensateur CL, par exemple identique ou similaire au condensateur CH, ayant une première électrode reliée, par exemple connectée, à la borne 207 du composant 200 et une deuxième électrode reliée, par exemple connectée, à la borne 102 du composant 200. Les condensateurs CH et CL sont par exemple des condensateurs discrets externes au circuit 150 et au composant 200.

Le fonctionnement du circuit de la figure 2 est similaire à celui du circuit de la figure 1. En particulier, pour fermer le transistor T1, le circuit CTRL commande l'ouverture de l'interrupteur SL et la fermeture de l'interrupteur SH. Ceci conduit à l'application d'une tension sensiblement égale à la tension VH entre la grille et la source du transistor T1, entraînant la fermeture du transistor T1. Pour ouvrir le transistor T1, le circuit CTRL commande l'ouverture de l'interrupteur SH et la fermeture de l'interrupteur SL. Ceci conduit à l'application d'une tension sensiblement égale à la tension VL entre la grille et la source du transistor T1, entraînant l'ouverture du transistor T1.

En fonctionnement normal, les condensateurs CH et CL sont chargés respectivement à la tension VH et à la tension VL.

En cas de pic de surtension positif sur la grille du transistor T1, si la valeur de la surtension dépasse la tension VH plus la tension de seuil de la diode SC1, la surtension est évacuée par l'intermédiaire de la diode SC1 et du condensateur CH, ce qui permet de protéger la grille du transistor T1. En cas de pic de surtension négatif sur la grille du transistor T1, si la valeur de la surtension dépasse la tension VL moins la tension de seuil de la diode SC2, la surtension est évacuée par l'intermédiaire de la diode SC2 et du condensateur CL, ce qui permet de protéger l'oxyde de grille du transistor T1. A titre d'exemple, la chute de tension en direct de chacune des diodes SC1 et SC2 est de l'ordre de 0,6 V à 10 mA et de l'ordre de 1,2 V à 4 A.

Un avantage du mode de réalisation de la figure 2 est de permettre de protéger la grille du transistor T1 sans avoir à limiter la vitesse de commutation du transistor T1. En particulier, par rapport au montage de la figure 1, les résistances RH et/ou RL peuvent être réduites, voire supprimées complètement comme représenté sur la figure 2.

Le fait que les diodes Schottky SC1 et SC2 soient intégrées de façon monolithique dans et sur le même substrat semiconducteur que le transistor T1 permet de rendre négligeables les inductances parasites de connexion entre les diodes SC1 et SC2 et la grille du transistor T1. Ceci permet une évacuation particulièrement rapide des surtensions positives et négatives dès leur apparition.

Dans cet exemple, les condensateurs CH et CL sont des composants externes, par exemple soudés directement aux bornes 205, 207 et 102 du composant 200. Ceci permet de limiter la surface du substrat au nitrure de gallium du composant 200. A titre de variante, les condensateurs CH et CL peuvent être intégrés de façon monolithique dans et/ou sur le substrat au nitrure de gallium du composant 200.

A titre d'exemple, chacun des condensateurs CH et CL a une capacité comprise entre 10 et 500 nF, par exemple de l'ordre de 220 nF.

Les diodes SC1 et SC2 peuvent être des diodes relativement basse tension. A titre d'exemple, les diodes SC1 et SC2 ont une tenue en tension en inverse inférieure à 50 V, par exemple de l'ordre de 30 V. Chacune des diodes SC1 et SC2 occupe par exemple une surface du substrat au nitrure de gallium comprise entre 0,2 et 2 mm², par exemple comprise entre 0,5 et 1,5 mm².

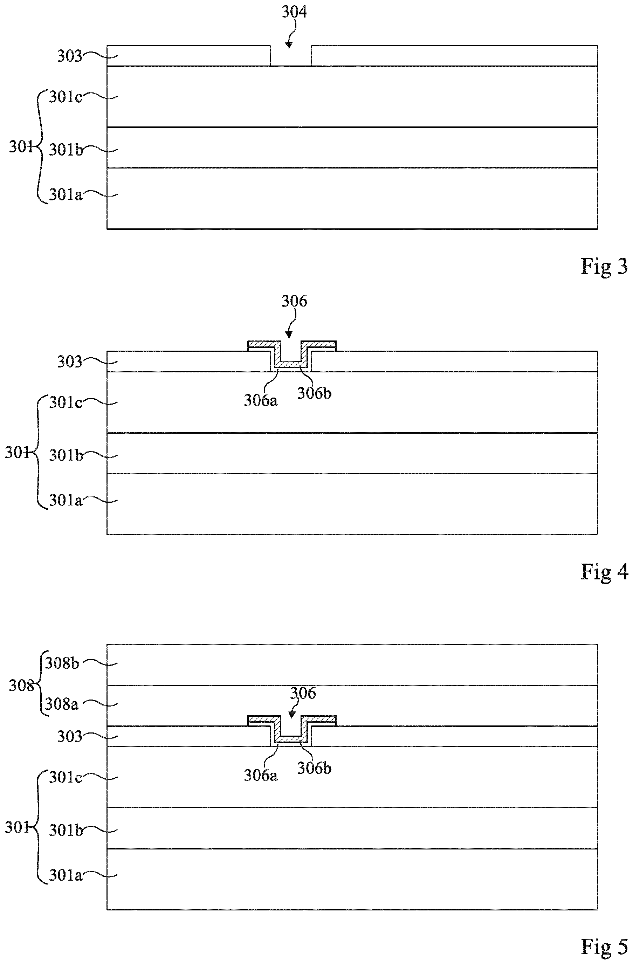

Les figures 3 à 10 illustrent de façon schématique et partielle des étapes d'un exemple de procédé de fabrication du composant monolithique 200 de la figure 2. Dans cet exemple, le transistor T1 est un transistor HEMT.

La figure 3 est une vue en coupe représentant un substrat au nitrure de gallium 301. Dans cet exemple, le substrat comprend une couche 301a de nitrure de gallium dopé au carbone, une couche 301b de nitrure de gallium dopé au magnésium, disposée sur et en contact avec la face supérieure de la couche 301a, et une couche 301c de nitrure de gallium non intentionnellement dopé, disposée sur et en contact avec la face supérieure de la couche 301b. La couche 301c est par exemple formée par épitaxie à partir de la face supérieure de la couche 301b. Le substrat 301 peut lui-même reposer sur un support, non représenté, par exemple en silicium ou en saphir. A titre de variante, les couches 301a et 301b peuvent être remplacées par toute autre couche ou tout autre empilement de couches permettant la formation de la couche épitaxiée 301c.

La figure 3 illustre une étape de formation d'une couche 303 de nitrure d'aluminium-gallium sur et en contact avec la face supérieure de la couche 301c. La couche 303 peut être formée de façon continue sur toute la surface supérieure du substrat 301, par exemple par épitaxie.

La figure 3 illustre en outre la formation, dans la couche 303, en vis-à-vis de la future région de grille du transistor T1, d'une ouverture traversante localisée 304 débouchant sur la face supérieure de la couche de nitrure de gallium 301c. L'ouverture 304 peut être formée par photolithographie et gravure.

La figure 4 est une vue en coupe illustrant une étape ultérieure de formation d'un empilement de grille isolée 306 dans l'ouverture 304. L'empilement de grille isolée 306 peut comprendre une couche diélectrique 306a, par exemple en oxyde de silicium, disposée sur et en contact avec la face supérieure de la couche de nitrure de gallium 301c, au fond de l'ouverture 304, et une couche conductrice 306b, par exemple métallique, disposée sur et en contact avec la face supérieure de la couche 306a. Les couches 306a et 306b correspondent respectivement à l'isolant de grille et au conducteur de grille du transistor T1. Dans l'exemple représenté, l'empilement de grille isolée 306 s'étend non seulement au fond de l'ouverture 304, sur et en contact avec la face supérieure de la couche 301c, mais s'étend en outre sur et en contact avec les parois latérales de l'ouverture 304, et sur et en contact avec une partie de la face supérieure de la couche 303, à la périphérie de l'ouverture 303. A titre d'exemple, pour former l'empilement de grille isolée 306, les couches 306a et 306b sont d'abord successivement déposées de façon continue, sur toute la surface supérieure de la structure obtenue après la formation de l'ouverture 304 dans la couche 303, puis les couches 306a et 306b sont gravées de façon localisée, par exemple par photolithographie et gravure, pour ne conserver que l'empilement de grille 306.

La figure 5 est une vue en coupe illustrant une étape ultérieure de dépôt d'une couche de passivation 308 sur la face supérieure de la structure obtenue après la formation de l'empilement de grille 306. Dans cet exemple, la couche de passivation 308 comprend une couche 308a de nitrure de silicium disposée sur et en contact avec la face supérieure de la couche 303 de nitrure d'aluminium-gallium et sur et en contact avec la face supérieure de l'empilement de grille isolée 306, et une couche 308b d'oxyde de silicium disposée sur et en contact avec la face supérieure de la couche 308a. La couche de passivation 308 s'étend par exemple de façon continue sur toute la surface supérieure de la structure obtenue après la formation de l'empilement de grille isolée 306.

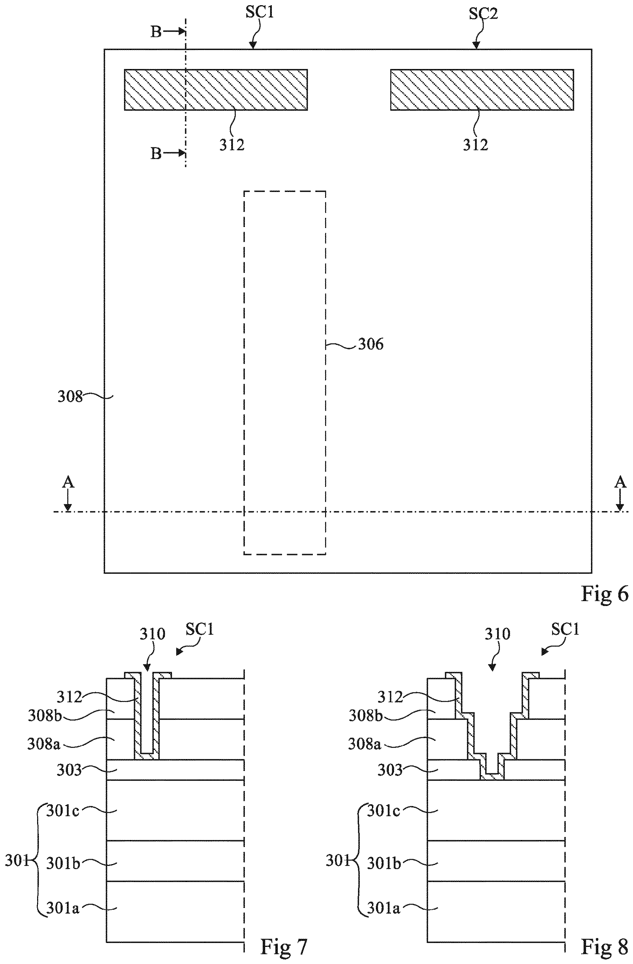

Les figures 6 et 7 sont respectivement une vue de dessus et une vue en coupe illustrant des étapes ultérieures de formation de métallisations d'anode 312 des diodes Schottky SC1 et SC2. Sur la figure 6, des axes A-A et B-B ont été représentés, correspondant respectivement au plan de coupe des figures 3, 4 et 5, et au plan de coupe de la figure 7.

Dans cet exemple, la barrière Schottky de chacune des diodes SC1 et SC2 est formée entre la face supérieure de la couche de nitrure d'aluminium-gallium 303 et la métallisation d'anode 312 de la diode. Pour chacune des diodes SC1 et SC2, une tranchée localisée 310 est d'abord formée à partir de la face supérieure de la couche 308, la tranchée 310 s'étendant verticalement à travers la couche 308 et débouchant sur la face supérieure de la couche 303 ou à un niveau intermédiaire de l'épaisseur de la couche 303, en vis-à-vis de la future métallisation d'anode 312 de la diode. La tranchée 310 est par exemple formée par photolithographie et gravure. La métallisation 312 est ensuite déposée en contact avec la face supérieure de la couche 303 au fond de la tranchée 310. La métallisation 312 est par exemple en nitrure de titane ou en tungstène. Dans l'exemple représenté, la métallisation 312 s'étend non seulement au fond de la tranchée 310 sur et en contact avec la face supérieure de la couche 303, mais également sur et en contact avec les parois latérales de la tranchée 310 et sur et en contact avec la face supérieure de la couche de passivation 308 à la périphérie de la tranchée 310. A titre d'exemple, une couche du ou des matériaux constituant la métallisation 312 est d'abord déposée de façon continue sur toute la surface supérieure de la structure obtenue après la formation des tranchées 310, puis cette couche est gravée de façon localisée, par exemple par photolithographie et gravure, pour ne conserver que les métallisations de contact d'anode 312 des diodes SC1 et SC2.

A titre de variante, la barrière Schottky peut être formée entre la face supérieure de la couche de nitrure de gallium 301c et la métallisation d'anode 312 de chaque diode. Dans ce cas, la tranchée 310 se prolonge jusqu'à la face supérieure de la couche 301c ou jusqu'à un niveau intermédiaire de l'épaisseur de la couche 301c.

On notera que la tranchée 310 peut comporter une ou plusieurs marches formées aux différentes interfaces rencontrées, par exemple sur la couche 308a, sur la couche 303, ou, le cas échéant, sur la couche 301c, tel qu'illustré sur la figure 8.

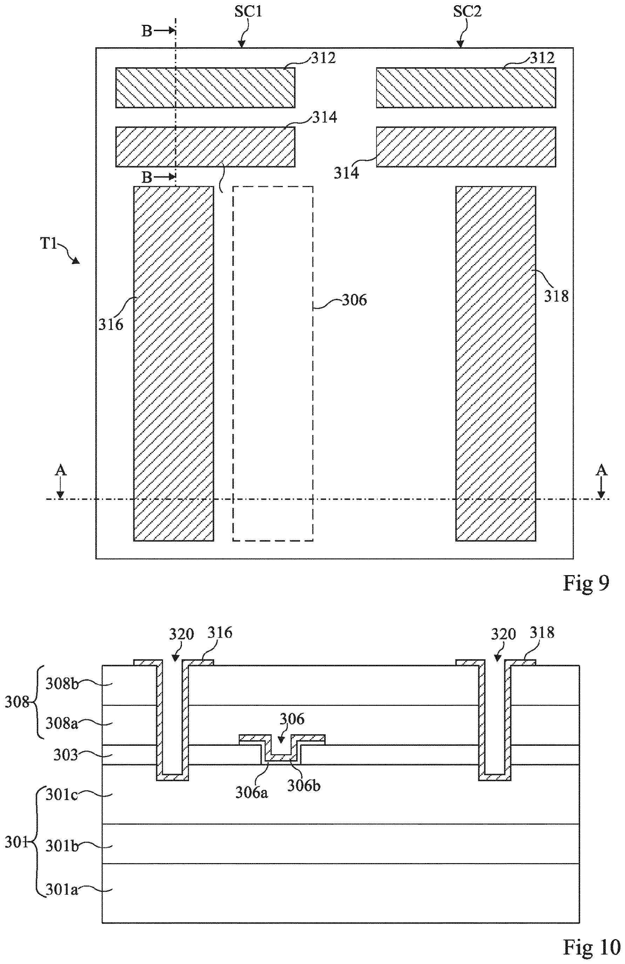

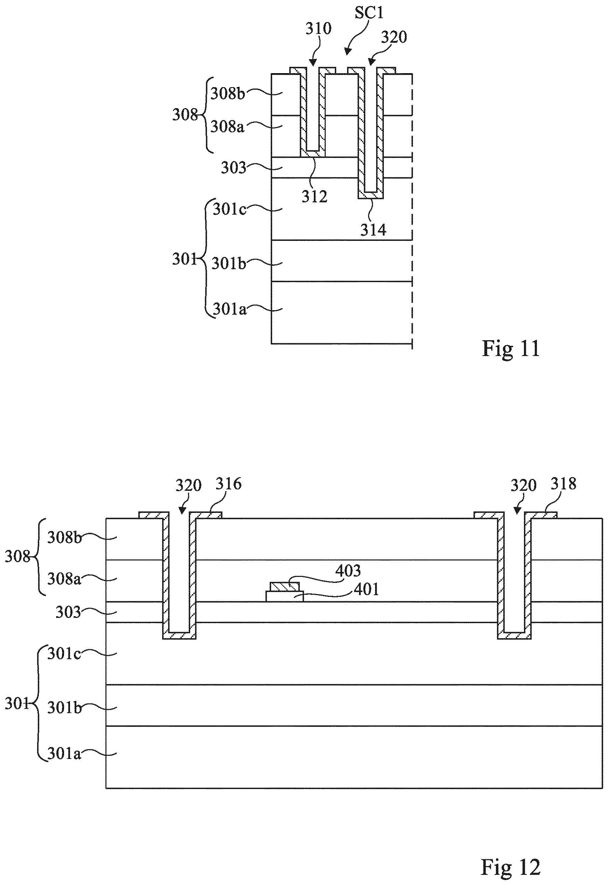

Les figures 9, 10 et 11 sont respectivement une vue de dessus et des vues en coupe illustrant des étapes ultérieures de formation des régions conductrices de contact de cathode 314 des diodes Schottky SC1 et SC2 et des régions conductrices de contact de source 316 et de drain 318 du transistor T1. Sur la figure 9, des axes A-A et B-B ont été représentés, correspondant respectivement au plan de coupe de la figure 10 (identique au plan de coupe des figures 3, 4 et 5) et au plan de coupe de la figure 11 (identique au plan de coupe de la figure 7).

Dans cet exemple, les régions conductrices de contact 314, 316 et 318 sont formées simultanément. Pour chacune des régions conductrices de contact 314, 316 et 318, une tranchée localisée 320 est d'abord formée à partir de la face supérieure de la couche 308, la tranchée 320 s'étendant verticalement à travers les couches 308 et 303 et débouchant dans la couche 301c ou sur la face supérieure de la couche 301c. Les tranchées 320 sont par exemple formées par photolithographie et gravure. La région conductrice de contact 314, respectivement 316, respectivement 318, est ensuite déposée en contact avec la face supérieure de la couche 301c au fond de la tranchée 320. Chacune des régions conductrices de contact 314, 316 et 318 forme un contact ohmique avec la couche de nitrure de gallium 301c au fond de la tranchée 320 correspondante. Les régions conductrices de contact 314, 316 et 318 sont par exemple en métal. Dans l'exemple représenté, chacune des régions conductrices de contact 314, 316 et 318 s'étend non seulement au fond de la tranchée 320 correspondante, sur et en contact avec la face supérieure de la couche 301c, mais également sur et en contact avec les parois latérales de la tranchée et sur et en contact avec la face supérieure de la couche de passivation 308 en périphérie de la tranchée 320. A titre d'exemple, une couche du ou des matériaux constituant les régions conductrices de contact 314, 316 et 318 est d'abord déposée de façon continue sur toute la surface supérieure de la structure obtenue après la formation des tranchées 320, puis cette couche est gravée de façon localisée, par exemple par photolithographie et gravure, pour ne conserver que les régions conductrices de contact 314, 316 et 318.

Des étapes ultérieures (non détaillées sur les figures) de dépôt d'un ou plusieurs niveaux métalliques supérieurs d'interconnexion, par exemple trois niveaux métalliques séparés deux à deux par des niveaux isolants, peuvent ensuite être mises en oeuvre pour connecter l'anode de la diode SC1 et la cathode de la diode SC2 à la grille du transistor T1, et pour former les plots de connexion 101, 102, 103, 205 et 207 connectés respectivement au drain du transistor T1, à la source du transistor T1, à la grille du transistor T1, à la cathode de la diode SC1, et à l'anode de la diode SC2.

Dans l'exemple décrit en relation avec les figures 3 à 11, le transistor T1 est un transistor de type métal-oxyde-semiconducteur (MOS). Les modes de réalisation décrits ne se limitent toutefois pas à ce cas particulier. A titre de variante, le transistor T1 peut être un transistor JFET, ou transistor à effet de champ à jonction, comportant une grille conductrice formant un contact ohmique ou un contact Schottky avec une couche semiconductrice.

La figure 12 est une vue en coupe dans le même plan que la figure 10, illustrant une variante de réalisation dans laquelle le transistor T1 est un transistor JFET.

Dans l'exemple de la figure 12, l'étape de formation de l'ouverture 304 dans la couche 303 (figure 3) est omise. A la place, une région semiconductrice 401 à base de nitrure de gallium, par exemple une région en nitrure de gallium dopé de type P, est formée par épitaxie localisée sur la face supérieure de la couche 303, en vis-à-vis de la future région de grille du transistor. Une métallisation 403 est ensuite formée sur et en contact avec la face supérieure de la région 401. La métallisation 403 forme un contact ohmique ou un contact Schottky avec la région 401, et constitue la grille du transistor T1.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas à l'exemple de procédé de fabrication du composant 200 décrit en relation avec les figures 3 à 12.

De plus, les modes de réalisation décrits ne se limitent pas à l'exemple décrit ci-dessus dans lequel le composant 200 comprend deux diodes Schottky de protection SC1 et SC2. Dans certaines applications, il est suffisant que la grille du transistor T1 soit protégée contre les pics de surtension positifs seulement. Dans ce cas, la diode SC2 et le plot de connexion 207 du composant 200 peuvent être omis. De plus, le condensateur CL du circuit de la figure 2 peut être omis. Dans d'autres applications, il est suffisant que la grille du transistor T1 soit protégée contre des pics de surtensions négatifs seulement. Dans ce cas, la diode SC1 et le plot de connexion 205 du composant 200 peuvent être omis. De plus, le condensateur CH du circuit de la figure 2 peut être omis.

## Revendications

1. Composant (200) monolithique comportant un transistor de puissance à effet de champ (T1), une première diode Schottky (SC1) et une deuxième diode Schottky (SC2) dans et sur un même substrat au nitrure de gallium (301), dans lequel la première diode Schottky (SC1) a une première électrode connectée à la grille (g) du transistor (T1) et une deuxième électrode connectée à une première borne de connexion (205) du composant (200),
dans lequel la deuxième diode Schottky (SC2) a une première électrode connectée à la grille (g) du transistor (T1) et une deuxième électrode connectée à une deuxième borne de connexion (207) du composant,
le composant monolithique comportant en outre une borne de connexion de drain (101), une borne de connexion de source (102) et une borne de connexion de grille (103), distinctes des première (205) et deuxième (207) bornes de connexion, connectées respectivement au drain (d), à la source (s) et à la grille (g) du transistor (T1).

2. Composant (200) selon la revendication 1, dans lequel la première borne de connexion (205) est destinée à recevoir une première tension fixe (VH) correspondant à une tension de commande du transistor (T1) dans un premier état, fermé ou ouvert.

3. Composant (200) selon la revendication 1 ou 2, dans lequel la deuxième borne de connexion (207) est destinée à recevoir une deuxième tension fixe (VL) correspondant à une tension de commande du transistor (T1) dans un deuxième état, ouvert ou fermé.

4. Circuit comportant :
- un composant (200) selon l'une quelconque des revendications 1 à 3 ; et
- un premier condensateur (CH) connecté entre la première borne de connexion (205) du composant (200) et la borne de connexion de source (102) du composant (200).

5. Circuit selon la revendication 4, comportant en outre un deuxième condensateur (CL) connecté entre la deuxième borne de connexion (207) du composant (200) et la borne de connexion de source (102) du composant (200).

6. Circuit selon la revendication 4 ou 5, comportant en outre un circuit de commande (150) comportant une première borne de connexion (151) fournissant une première tension fixe (VH) correspondant à une tension de commande du transistor (T1) dans un premier état, fermé ou ouvert, une deuxième borne de connexion (152), et un premier interrupteur commandé (SH) reliant la première borne de connexion (151) du circuit de commande (150) à la deuxième borne de connexion (152) du circuit de commande (150), la première borne de connexion (151) du circuit de commande (150) étant connectée à la première borne de connexion (205) du composant (200), et la deuxième borne de connexion (152) du circuit de commande (150) étant reliée à la borne de connexion de grille (103) du composant (200).

7. Circuit selon la revendication 6 dans son rattachement à la revendication 5, dans lequel le circuit de commande (150) comporte une troisième borne de connexion (154) fournissant une deuxième tension fixe (VL) correspondant à une tension de commande du transistor (T1) dans un deuxième état, ouvert ou fermé, une quatrième borne de connexion (153), et un deuxième interrupteur commandé (SL) reliant la troisième borne de connexion (154) du circuit de commande (150) à la quatrième borne de connexion (153) du circuit de commande (150), la troisième borne de connexion (154) du circuit de commande (150) étant connectée à la deuxième borne de connexion (207) du composant (200), et la quatrième borne de connexion (153) du circuit de commande (150) étant reliée à la borne de connexion de grille (103) du composant (200).

8. Procédé de fabrication d'un composant (200) selon l'une quelconque des revendications 1 à 3, comportant les étapes successives suivantes :
a) prévoir un substrat (301) au nitrure de gallium ;
b) former la grille du transistor (T1) du côté de la face supérieure du substrat (301) ;
c) déposer une couche de passivation (308) ;
d) former une tranchée (310) dans la couche de passivation (308) ; et
e) former dans ladite tranchée (310) une métallisation définissant l'anode de la première diode Schottky (SC1).

9. Procédé selon la revendication 8, dans lequel :
- avant l'étape b), le substrat (301) est revêtu d'une couche de nitrure d'aluminium-gallium (303) ;
- à l'étape d), la tranchée (310) formée dans la couche de passivation (308) débouche dans ou sur la couche de nitrure d'aluminium-gallium (303), ou dans ou sur le substrat (301) ; et
- à l'étape e), la métallisation formée dans ladite tranchée (310) forme un contact Schottky avec la couche de nitrure d'aluminium-gallium (303), ou avec le substrat (301) .

10. Procédé selon la revendication 8 ou 9, dans lequel, à l'étape b), une ouverture localisée (304) débouchant dans ou sur le substrat (301) est formée dans la couche de nitrure d'aluminium-gallium (303), puis un empilement de grille isolée (306) définissant la grille du transistor (T1) est formé dans ladite ouverture.

11. Procédé selon la revendication 9, dans lequel, à l'étape b), une région semiconductrice (401) à base de nitrure de gallium est formée par épitaxie localisée sur la face supérieure de la couche de nitrure d'aluminium-gallium (303), puis une métallisation (403) définissant la grille du transistor (T1) est formée sur et en contact avec la face supérieure de ladite région (401).

12. Procédé selon l'une quelconque des revendications 8 à 11, comportant en outre, après la formation de la couche de passivation (308), les étapes successives suivantes :
- former simultanément dans la couche de passivation (308) de première, deuxième et troisième tranchées (320) débouchant dans ou sur le substrat (301) ; et
- former simultanément dans les première, deuxième et troisième tranchées (320) des première (314), deuxième (316) et troisième (318) métallisations formant chacune un contact ohmique avec le substrat (301) et définissant respectivement un contact de cathode de la première diode Schottky (SC1), un contact de source (s) du transistor (T1) et un contact de drain (d) du transistor (T1).
